# EUROPEAN PATENT SPECIFICATION

(11) **EP 0 372 526 B1**
(45) Date of publication and mention of the grant of the patent: **19.06.1996**
(21) Application number: 89122485.9
(22) Date of filing: 06.12.1989
(51) Int. Cl.: G06F 3/05, H03M 1/12

(54) **Microcomputer having high speed a/d conversion function**
Mikrorechner mit A/D-Wandlungsfunktion hoher Geschwindigkeit
Microcalculateur à fonction de conversion analogique-numérique à haute vitesse

(30) Priority: 06.12.1988 JP 309292/88
(43) Date of publication of application: 13.06.1990
(73) Proprietor: NEC CORPORATION, Tokyo (JP)
(72) Inventor: Ishimoto, Satomi c/o Nec Corporation, Minato-ku Tokyo (JP); Matsushima, Osamu c/o Nec Corporation, Minato-ku Tokyo (JP); Maehashi, Yukio c/o Nec Corporation, Minato-ku Tokyo (JP)
(74) Representative: Betten & Resch

(56) References cited:
- EP-A- 0 006 779
- US-A- 3 493 731
- US-A- 4 364 029
- ELECTRONIC DESIGN vol. 31, no. 20, 29 September 1983, DENVILLE NJ pages 227 - 232; DAVIS ET AL: 'DATA ACQUISITION MOVES INTO THE REALM OF PCS'
- ELECTRONIQUE INDUSTRIELLE no. 20, May 1988, PARIS FRANCE pages 28 - 33; CRESCENZO ET AL.: 'MICROCONTROLEUR 16 BITS'

## Description

### Background of the Invention

### Field of the invention

The present invention relates to a microcomputer, and more specifically to a microcomputer containing an analog-to-digital (A/D) conversion function therein.

### Description of related art

Conventionally, a head for data reading and writing of hard disks and floppy disks has been positionally servo-controlled to trace a track on the disk. This servo-control has been effected by obtaining a current head position by detecting a servo-pattern previously recorded between a data region and an adjacent data region on the track, in synchronism with and with reference to a termination of each data region, and by deriving a difference between the detected head position and a target track so as to modify the position of the head.

Here, assume that four data tracks A, B, C and D are concentrically formed at different radii on a disk, and the data tracks A, B, C and D respectively include data regions A1, B1, C1 and D1 which are located in the same sector zone and are angularly separated from data regions A2, B2, C2 and D2 in an adjacent sector zone, with servo patterns PA, PB, PC and PD being interposed between the data regions A1, B1, C1 and D1 and the data regions A2, B2, C2 and D2, respectively. Therefore, these servo patterns PA, PB, PC and PD are detected by a head in the course of movement of the head from an end of the data regions A1, B1, C1 and D1 to a beginning of the data regions A2, B2, C2 and D2.

However, these servo patterns PA, PB, PC and PD are located at different angular positions within an angular zone between the sector zone including the data regions A1, B1, C1 and D1 and the sector zone including the data regions A2, B2, C2 and D2. Therefore, the servo pattern PA is detected at a timing TA after the end of the data region A1 is detected, and after the end of the data region B1 is detected, the servo pattern PB is detected at a timing TB different from the timing TA. In addition, after the end of the data region C1 is detected, the servo pattern PC is detected at a timing TC different from each of the timings TA and TB, and after the end of the data region D1 is detected, the servo pattern PD is detected at a timing TD different from each of the timings TA, TB and TC. Therefore, the position of the head can be detected by converting into a digital signal an analog read signal outputted from the head when the head passes in front of a position corresponding to the timing TA, TB, TC or TD after the head has passed the end of the sector zone including the data regions A1, B1, C1 and D1.

For example, here assuming that the head is on the track C, after the head detects the end of the sector zone including the data regions A1, B1, C1 and D1, reading signals outputted from the head at the timings TA, TB and TD are almost 0V, respectively, and on the other hand, a reading signal outputted from the head at the timing TC becomes about 5V. As a result, it is detected that the head is on the track C. In addition, even if the head is at an intermediate position between tracks, the position of the head can be determined by examining the reading signal outputted from the head.

However, it has been an ordinary practice that an area for the servo pattern is in a range corresponding to several hundred microseconds, and a width of the servo pattern itself substantially corresponds to 100 microseconds. Therefore, even in the case that the head position discrimination on the basis of digital information obtained by an analog-to-digital (A/D) conversion of the reading signal outputted from the head is allowed to be considerably delayed in time, since the change of the analog voltage occurs in a very short time, a high speed A/D converter such as a flash type A/D converter has been required. Accordingly, it has not been possible to use a relatively inexpensive successive approximation A/D converter.

The flash type A/D converter can execute an A/D conversion at one time, but needs 2⁸ comparators for A/D conversion in a 8-bit resolution, for example. Therefore, the flash type A/D converter is very expensive and requires a large chip size. Accordingly, it has not been possible to assemble the flash type A/D converter on a single chip microcomputer. In other words, application systems have been expensive.

In addition, since it has been necessary to provide a discrete A/D converter independently of a microcomputer, the microcomputer has to be coupled to receive an output of the A/D converter for the purpose of discriminating the position of the head. As a result, the board size has been inevitably large, and an increased cost for wiring has been required. Further, reliability has been low.

In the prior art, furthermore, when a plurality of analog inputs must be converted into a digital signal at the same timing, respectively, it has been required to provide a corresponding number of A/D converters. Therefore, a further increased cost has been required.

As mentioned above, in the conventional A/D converter systems, an expensive A/D converter for conversion of an input analog signal varying in a short time has to have been provided externally of a microcomputer. As a result, application systems have required an increased cost for integrated circuits, and therefore, have not been so economical and could not have a satisfactory reliability.

In US-A-3,493,731 there is described a hybrid computing system including a digital system and an analog system provided with a data conversion unit interconnecting the two systems and including a plurality of sample-hold amplifiers connected by a multiplexing unit to an analog to digital converter which amplifiers may be selected by execution of a single digital program instruction the selection being either individually or in any group of amplifiers up to the total number of amplifiers.

### Summary of the Invention

Accordingly, it is an object of the present invention to provide a microcomputer having an A/D conversion function, which has overcome the above mentioned defect of the conventional one.

Another object of the present invention is to provide a microcomputer having an A/D conversion function, which is inexpensive and can convert into a digital signal an analog signal which varies in a short time.

The above and other objects of the present invention are achieved in accordance with the present invention by a microcomputer which includes an central processing unit and an A/D conversion circuit formed on the same integrated circuit chip, as described in the claims.

The above and other objects, features and advantages of the present invention will be apparent from the following description of preferred embodiments of the invention with reference to the accompanying drawings.

### Brief Description of the Drawings

Figure 1 is a block diagram of an embodiment of the microcomputer in accordance with the present invention;
Figure 2 is a timing chart illustrating an operation of the microcomputer shown in Figure 1; and
Figure 3 is a block diagram of a modification of the microcomputer shown in Figure 1.

### Description of the Preferred embodiments

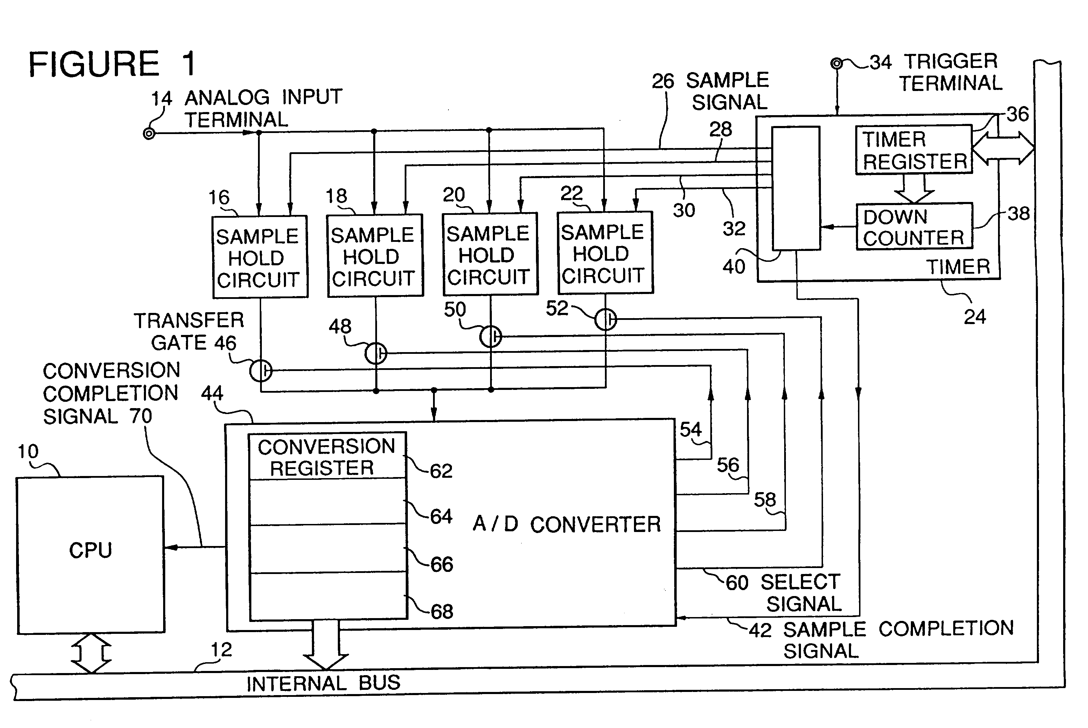

Referring to Figure 1, there is shown a block diagram of an embodiment of the microcomputer in accordance with the present invention.

The shown microcomputer includes a central processing unit (CPU) 10 coupled to an internal bus 12, and an analog input terminal 14 commonly coupled to four sample and hold circuits 16, 18, 20 and 22. These four sample and hold circuits 16, 18, 20 and 22 are also coupled to a timer 24 so as to receive sample signals 26, 28, 30 and 32, respectively, so that the four sample and hold circuits 16, 18, 20 and 22 respectively sample and hold a input analog voltage when the sample and hold circuit receives a corresponding sample signal.

The timer 24 is coupled to a trigger terminal 34 so as to be initialized in response to a trigger signal supplied through the trigger terminal 34. The timer 24 includes a timer register 36 coupled to the internal bus 12 so that the timer register 36 is set with arbitrary data by the central processing unit 10. This timer register 36 is coupled to an down counter 38 so as to output the data set in the timer register 36 to the down counter 38. The down counter 38 is loaded with the data of the timer register 36 in synchronism with the trigger signal 34, and thereafter, operates to count down or decrement the loaded data. When the value of the down counter 38 becomes zero, the down counter 38 generates an output signal to an output control circuit 40, which generates, on the basis of the output from the down counter 38, the above mentioned sample signals 26, 28, 30 and 32 and a sample completion signal 42 indicating that all the sample and hold circuits 16, 18, 20 and 22 have held new analog voltages.

Outputs of the sample and hold circuits 16, 18, 20 and 22 are inputted to an common analog voltage input of an A/D converter 44 through transfer gates 46, 48, 50 and 52, respectively. The A/D converter 44 responds to the sample completion signal 42 to sequentially output select signals 54, 56, 58 and 60 to the transfer gates 46, 48, 50 and 52, respectively, so that the four analog voltages held in the sample and hold circuits 16, 18, 20 and 22 are selectively sequentially supplied to the A/D converter 44 one by one in accordance with the select signals 54, 56, 58 and 60. The selected analog voltage is converted into a digital data by the A/D converter 44, and the digital data is stored in a corresponding one of four conversion registers 62, 64, 66 and 68 provided in the A/D converter 44. When the A/D converter 44 has completed an A/D conversion of all the four analog voltages held in the sample and hold circuits 16, 18, 20 and 22, the A/D converter 44 generates a conversion completion signal 70 to the central processing unit 10. On the other hand, the four conversion registers 62, 64, 66 and 68 are coupled to the internal bus 12 so that contents of the conversion registers 62, 64, 66 and 68 can be read by the central processing unit 10.

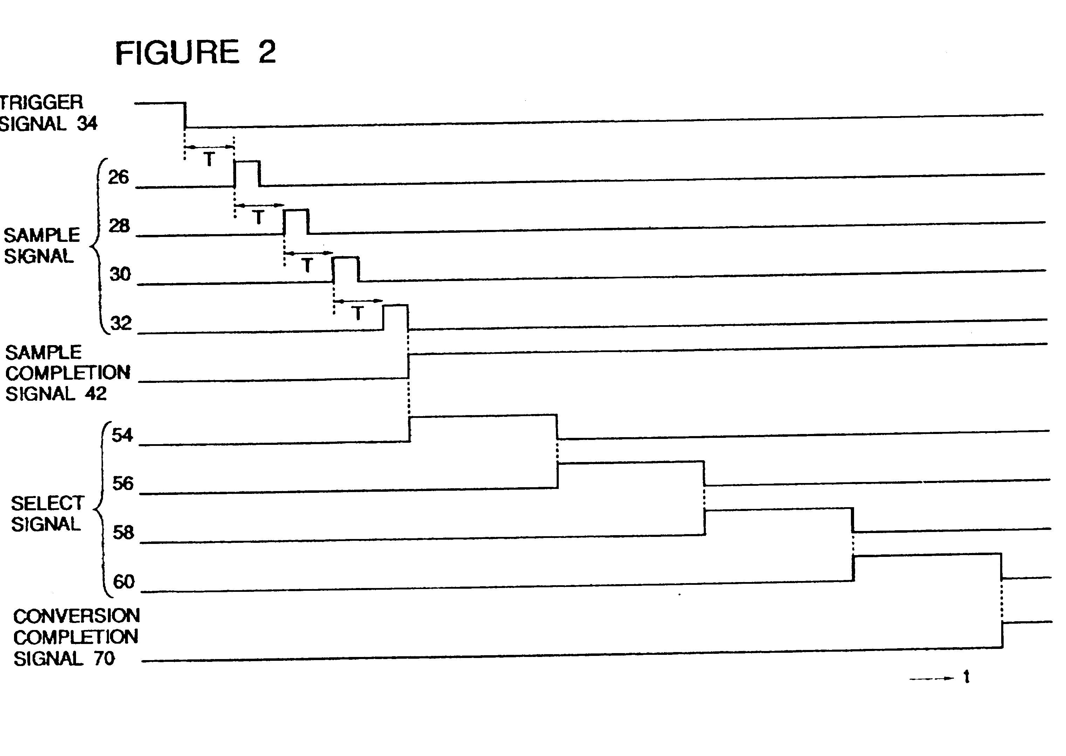

Now, operation of the microprocessor will be decribed with reference to Figure 2 showing a timing chart illustrating an operation of the microcomputer shown in Figure 1.

In synchronism with a fall edge of the trigger signal 34, the value previously set in the timer register 36 of the timer 24 is loaded to the down counter 38, and the down counter 38 starts to decrement the loaded value at each predetermined interval, or at each clock. When the value of the down counter 38 becomes "0" or zero, the down counter 38 outputs the signal to the output control circuit 40, which generates the first sample signal 26. The timer 24 repeats the above mentioned decrement operation four times, and sequentially generates the sample signals 26, 28 30 and 32, as shown in Figure 2. An interval T between the fall edge of the trigger signal 34 and a rising edge of the first sample signal 26 are the same as that between rising edges of each pair of adjacent sample signals, and is determined by the set value of the timer register 36 and a decrementing speed or clock of the down counter 38.

Therefore, the output control circuit 40 of the timer 24 respectively generates the sample signals 26, 28 30 and 32 at different timings T, 2T, 3T and 4T after the fall edge of the trigger signal 34. The sample and hold circuit 16, 18, 20 and 22 sample and hold the input analog voltage on the input terminal 14 when the corresponding sample signal is at ˝1˝.

The output control circuit 40 of the timer 24 outputs the sample completion signal 42 after generation of all the sample signals 16, 18, 20 and 22. In response to the sample completion signal 42, the A/D converter 44 brings the select signal 54 to "1" so as to open the transfer gate 46, so that the analog value held in the sample and hold circuit 16 is supplied to the A/D converter 44. The result of the A/D conversion of the analog value is stored in the conversion register 62 corresponding to the sample and hold circuit 16. After the result of the A/D conversion is stored in the conversion register, the A/D converter 44 activates a next select signal, namely, brings the select signal 48 to "1".

The above mentioned A/D conversion operation is repeated further three times, so that the result of the A/D conversion of the analog values held in all the sample and hold circuits 16, 18, 20 and 22 are stored in the corresponding conversion registers 62, 64, 66 and 68, respectively. Thereafter, the A/D converter 44 generates the conversion completion signal 70 to the central processing unit 10. In response to the conversion completion signal 70, the central processing unit 10 fetches the contents of the conversion registers through the internal bus 12, and executes a necessary processing on the basis of the result of the A/D conversion.

Since the above mentioned embodiment has only one A/D converter, an analog input varying in a short time can be inexpensively converted into digital data.

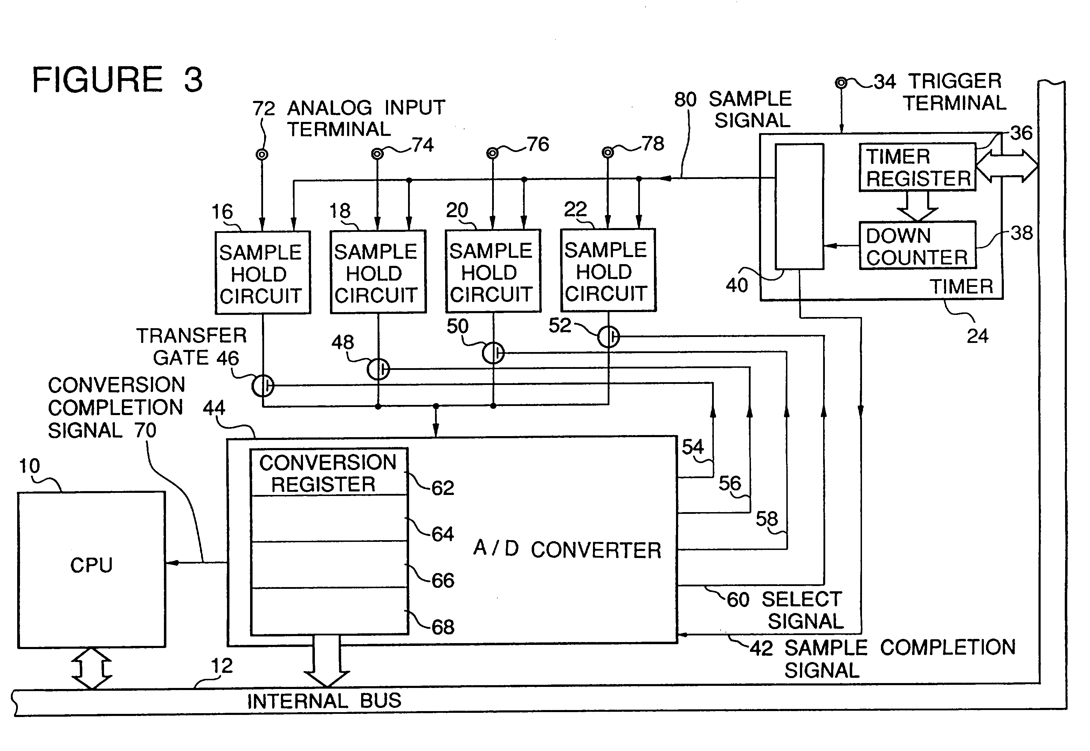

Turning to Figure 3, there is shown a modification of the microcomputer shown in Figure 1. Therefore, in Figure 3, elements corresponding or similar to those shown in Figure 1 are given the same Reference Numerals.

As seen from comparison between Figure 1 and 3, the microcomputer shown in Figure 3 is such that the four sample and hold circuits 16, 18, 20 and 22 are coupled to different input terminals 72, 74, 76 and 78, and also coupled to receive a common sample signal 80 outputted from the timer 24. Therefore, the four sample and hold circuits 16, 18, 20 and 22 simultaneously sample and hold different analog voltages supplied onto the input terminals 72, 74, 76 and 78, respectively. The other construction and operation of the microcomputer shown in Figure 3 are the same as those of the microcomputer shown in Figure 1, and therefore, further explanation will be omitted.

Since the above mentioned second embodiment also has only one A/D converter, a plurality of analog inputs at the same timing can be inexpensively converted into digital data.

In the above mentioned embodiments, the four sample and hold circuits are provided. However, the number of the sample and hold circuits is not limited, and can be freely increased. In addition, the number of analog input terminals can be increased.

Furthermore, the above mentioned embodiments are such that after all the sample and hold circuits have completed the sampling and holding of analog voltages, the A/D conversion is started. However, the above mentioned embodiments can be modified so that the A/D conversion is started as soon as an analog voltage has been held in one of the sample and hold circuits. In addition, in the above mentioned embodiments, the overall operation including the A/D conversion is timed by the trigger signal, but can be synchronized by a signal generated by a timer or other means.

The invention has thus been shown and described with reference to the specific embodiments. However, it should be noted that the present invention is in no way limited to the details of the illustrated structures.

## Claims

1. A microcomputer which includes a central processing unit (10) and an A/D conversion circuit formed on the same integrated circuit chip, comprising:
a plurality of sample and hold circuits (16, 18, 20, 22) coupled to input means (14; 72, 74, 76, 78) for sampling and holding an analog voltage supplied through the input means (14; 72, 74, 76, 78),
timing generation means (24) coupled to the plurality of sample and hold circuits (16, 18, 20, 22) for supplying an analog voltage sampling timing signal (26, 28, 30, 32) to the sample and hold circuits (16, 18, 20, 22),
means (34) coupled to the timing generation means (24) for initializing the timing generation means (24), and
means (46, 48, 50, 52) coupled to the sample and hold circuits (16, 18, 20, 22) and the A/D conversion circuit for sequentially selecting one of the analog voltages held in the sample and hold circuits (16, 18, 20, 22) and supplying said selected analog voltage to the A/D conversion circuit, whereby the A/D conversion circuit sequentially converts said selected analog voltages into digital data one by one.

2. A microcomputer claimed in Claim 1 wherein the plurality of sample and hold circuits (16, 18, 20, 22) is coupled to a common analog input terminal (14) and the timing generation means (24) generates a corresponding number of analog voltage sampling timing signals (26, 28, 30, 32) at different timings of predetermined constant intervals and supplies the corresponding number of analog voltage sampling timing signals (26, 28, 30, 32) to the sample and hold circuits (16, 18, 20, 22), respectively, whereby the sample and hold circuits (16, 18, 20, 22) respectively sample and hold analog voltage on the common analog input terminal (14) at the different timings.

3. A microcomputer claimed in Claim 2 wherein the timing generation means (24) generates the corresponding number of analog voltage sampling timing signals (26, 28, 30, 32) after the timing generation means (24) is initialized by the initializing means (34), and the timing generation means (24) generates a sample completion signal (42) to the A/D conversion circuit after the timing generation means (24) has completed the generation of the corresponding number of analog voltage sampling timing signals (26, 28, 30, 32), whereby the A/D converter starts its A/D conversion after all the sample and hold circuits (16, 18, 20, 22) have sampled and held the analog voltages applied to the analog signal inputs of the sample and hold circuits (16, 18, 20, 22).

4. A microcomputer claimed in Claim 1 wherein the plurality of sample and hold circuits (16, 18, 20, 22) is coupled to a corresponding number of analog input terminals (72, 74, 76, 78) and the timing generation means (24) generates a common analog voltage sampling timing signal (80) to the sample and hold circuits (16, 18, 20, 22), respectively, whereby the sample and hold circuits (16, 18, 20, 22) respectively sample and hold analog voltages on the analog input terminals (72, 74, 76, 78) at the same timing.

5. A microcomputer claimed in Claim 1 wherein respective outputs of the sample and hold circuits (16, 18, 20, 22) are coupled to the A/D conversion circuit through a corresponding number of transfer gates (46, 48, 50, 52), which are controlled by the A/D conversion circuit and opened sequentially, whereby analog values stored in the sample and hold circuits (16, 18, 20, 22) are sequentially supplied one by one to the A/D conversion circuit.

6. A microcomputer claimed in Claim 1 wherein the A/D conversion circuit includes a plurality of conversion registers (62, 64, 66, 68) corresponding to the plurality of sample and hold circuits (16, 18, 20, 22), and operates to store an A/D conversion result of the analog value in the conversion register corresponding to the sample and hold circuit which has supplied the analog value to the A/D conversion circuit.

7. A microcomputer claimed in Claim 1 wherein the A/D conversion circuit includes
a plurality of sample and hold circuits (16, 18, 20, 22) each having an analog signal input, a sample timing control input and an output, each of the sample and hold circuits (16, 18, 20, 22) responding to a sample timing signal (26, 28, 30, 32, 80) applied to the sample timing control input by sampling and holding an analog voltage applied to the analog signal input, whereby the analog voltage held in the sample and hold circuit is output from the output of the sample and hold circuit,
an A/D converter (44) provided commonly to the plurality of sample and hold circuits (16, 18, 20, 22) and having an input for selectively sequentially receiving the outputs of the sample and hold circuits (16, 18, 20, 22) one by one and sequentially converting the received analog voltage into digital data;
and timing control means (40) for supplying the sample timing signals (26, 28, 30, 32) to the sample timing control input of the sample and hold circuits (16, 18, 20, 22), whereby the sample and hold circuits (16, 18, 20, 22) sample and hold the analog voltages applied to the analog signal inputs of the sample and hold circuits (16, 18, 20, 22), the timing control means (40) supplying a sample completion signal (42) to the A/D converter (44) after all the sample and hold circuits (16, 18, 20, 22) have sampled and held the analog voltages applied to the analog signal inputs of the sample and hold circuits (16, 18, 20, 22), whereby the A/D converter (44) starts its A/D conversion after all the sample and hold circuits (16, 18, 20, 22) have sampled and held the analog voltages applied to the analog signal inputs of the sample and hold circuits (16, 18, 20, 22).

8. A microcomputer claimed in Claim 7 wherein the timing control means (40) sequentially supply the sample timing signals (26, 28, 30, 32) to the sample timing control input of the sample and hold circuits (16, 18, 20, 22) at different timings, whereby the sample and hold circuits (16, 18, 20, 22) sequentially sample and hold the analog voltages applied to the analog signal inputs of the sample and hold circuits (16, 18, 20, 22), and the timing control means (40) supplies the sample completion signal (42) to the A/D converter (44) after the timing generation means (24) has supplied the corresponding sampling timing signals (26, 28, 30, 32) to all the sample and hold circuits (16, 18, 20, 22), whereby the A/D converter (44) executes its A/D conversion after all the sample and hold circuits (16, 18, 20, 22) have sampled and held the analog voltages applied to the analog signal inputs of the sample and hold circuits (16, 18, 20, 22).

## Patentansprüche

1. Mikrocomputer, der eine Zentraleinheit (10) und eine auf demselben integrierten Schaltungschip ausgebildete A/D-Wandlerschaltung enthält, mit:
einer Vielzahl von Abtast- und Halteschaltungen (16, 18, 20, 22), die mit Eingabeeinrichtungen (14; 72, 74, 76, 78) zum Abtasten und Halten einer durch die Eingabeeinrichtungen (14; 72, 74, 76, 78) gelieferten Analogspannung verbunden sind,
einer Taktgeneratoreinrichtung (24), die mit der Vielzahl von Abtast- und Halteschaltungen (16, 18, 20, 22) verbunden ist, um ein Analogspannungs-Abtasttaktsignal (26, 28, 30, 32) an die Abtast- und Halteschaltungen (16, 18, 20, 22) zu liefern,
einer Einrichtung (34), die mit der Taktgeneratoreinrichtung (24) verbunden ist, zum Initialisieren der Taktgeneratoreinrichtung (24), und
einer Einrichtung (46, 48, 50, 52), die mit den Abtast- und Halteschaltungen (16, 18, 20, 22) und der A/D-Wandlerschaltung verbunden ist, um sequentiell eine der in den Abtast- und Halteschaltungen (16, 18, 20, 22) gehaltenen Analogspannungen auszuwählen und die ausgewählte Analogspannung an die A/D-Wandlerschaltung zu liefern, wobei die A/D-Wandlerschaltung die ausgewählten Analogspannungen sequentiell eine nach der anderen in digitale Daten umwandelt.

2. Mikrocomputer nach Anspruch 1, wobei die Vielzahl der Abtast- und Halteschaltungen (16, 18, 20, 22) mit einem gemeinsamen analogen Eingangsanschluß (14) verbunden ist, die Taktgeneratoreinrichtung (24) eine entsprechende Anzahl an Analogspannungs-Abtasttaktsignalen (26, 28, 30, 32) zu unterschiedlichen Zeitpunkten von vorbestimmten konstanten Intervallen erzeugt und die entsprechende Anzahl an Analogspannungs-Abtasttaktsignalen (26, 28, 30, 32) jeweils an die Abtast- und Halteschaltungen (16, 18, 20, 22) liefert, wobei die Abtast-und Halteschaltungen (16, 18, 20, 22) jeweils die Analogspannung am gemeinsamen analogen Eingangsanschluß (14) zu unterschiedlichen Zeitpunkten abtasten und halten.

3. Mikrocomputer nach Anspruch 2, wobei die Taktgeneratoreinrichtung (24) die entsprechende Anzahl an Analogspannungs-Abtasttaktsignalen (26, 28, 30, 32) erzeugt, nachdem die Taktgeneratoreinrichtung (24) von der Initialisierungseinrichtung (34) initialisiert worden ist, und die Taktgeneratoreinrichtung (24) ein Abtast-Endesignal (42) für die A/D-Wandlerschaltung erzeugt, nachdem die Taktgeneratoreinrichtung (24) die Erzeugung der entsprechenden Anzahl an Analogspannungs-Abtasttaktsigalen (26, 28, 30, 32) abgeschlossen hat, wobei der A/D-Wandler mit der A/D-Wandlung erst beginnt, nachdem alle Abtast- und Halteschaltungen (16, 18, 20, 22) die Analogspannungen, die an die analogen Signaleingänge der Abtast- und Halteschaltungen (16, 18, 20, 22) angelegt wurden, abgetastet und gehalten haben.

4. Mikrocomputer nach Anspruch 1, wobei die Vielzahl von Abtast- und Halteschaltungen (16, 18, 20, 22) mit einer entsprechenden Anzahl an analogen Eingangsanschlüssen (72, 74, 76, 78) verbunden ist und die Taktgeneratoreinrichtung (24) jeweils ein gemeinsames Analogspannungs-Abtasttaktsignal (80) für die Abtast- und Halteschaltungen (16, 18, 20, 22) erzeugt, wobei die Abtast- und Halteschaltungen (16, 18, 20, 22) jeweils die Analogspannungen an den analogen Eingangsanschlüssen (72, 74, 76, 78) zum selben Zeitpunkt abtasten und halten.

5. Mikrocomputer nach Anspruch 1, wobei die jeweiligen Ausgänge der Abtast- und Halteschaltungen (16, 18, 20, 22) mit der A/D-Wandlerschaltung über eine entsprechende Anzahl an Transfergliedern (46, 48, 50, 52) verbunden sind, die von der A/D-Wandlerschaltung gesteuert und der Reihe nach geöffnet werden, wobei die in den Abtast- und Halteschaltungen (16, 18, 20, 22) gespeicherten Analogwerte sequentiell einer nach dem anderen an die A/D-Wandlerschaltung geliefert werden.

6. Mikrocomputer nach Anspruch 1, wobei die A/D-Wandlerschaltung eine Vielzahl von Wandlerregistern (62, 64, 66, 68) enthält, die der Vielzahl von Abtast-und Halteschaltungen (16, 18, 20, 22) entsprechen, und so arbeitet, daß ein A/D-Wandlungsergebnis des Analogwerts in dem Wandlerregister gespeichert wird, das der Abtast- und Halteschaltung, die den Analogwert an die A/D-Wandlerschaltung geliefert hat, entspricht.

7. Mikrocomputer nach Anspruch 1, wobei die A/D-Wandlerschaltung enthält:
eine Vielzahl von Abtast- und Halteschaltungen (16, 18, 20, 22), die jeweils einen analogen Signaleingang, einen Abtasttakt-Steuereingang und einen Ausgang haben, wobei jede der Abtast- und Halteschaltungen (16, 18, 20, 22) auf ein Abtasttaktsignal (26, 28, 30, 32), das an den Abtasttakt-Steuereingang angelegt wird, dadurch reagiert, daß sie eine an den analogen Signaleingang gelieferte Analogspannung abtastet und hält, wobei die in der Abtast- und Halteschaltung gehaltene Analogspannung aus dem Ausgang der Abtast- und Halteschaltung ausgegeben wird,
einen A/D-Wandler (44), der gemeinsam für die Vielzahl von Abtast- und Halteschaltungen (16, 18, 20, 22) zur Verfügung steht und einen Eingang aufweist, um die Ausgabesignale der Abtast- und Halteeinrichtungen (16, 18, 20, 22) der Reihe nach auszuwählen und sequentiell zu empfangen und um die empfangene Analogspannung sequentiell in digitale Daten zu wandeln;
und eine Taktsteuerungseinrichtung (40), um die Abtasttaktsignale (26, 28, 30, 32) an den Abtasttakt-Steuereingang der Abtast- und Halteschaltungen (16, 18, 20 22) zu liefern, wobei die Abtast- und Halteschaltungen (16, 18, 20, 22) die an die analogen Signaleingänge der Abtast- und Halteschaltungen (16, 18, 20, 22) angelegten Analogspannungen abtasten und halten und die Taktsteuereinrichtung (40) ein Abtast-Endesignal (42) an den A/D-Wandler liefert, nachdem alle Abtast-und Halteschaltungen (16, 18, 20, 22) die an die analogen Signaleingänge der Abtast- und Halteschaltungen (16, 18, 20, 22) angelegten Analogspannungen abgetastet und gehalten haben, wobei der A/D-Wandler (44) mit der A/D-Wandlung erst beginnt, nachdem alle Abtast- und Halteschaltungen (16, 18, 20, 22) die an die analogen Signaleingänge der Abtast- und Halteschaltungen (16, 18, 20, 22) angelegten Analogspannungen abgetastet und gehalten haben.

8. Mikrocomputer nach Anspruch 7, wobei die Taktsteuerungseinrichtung (40) die Abtasttaktsignale (26, 28, 30, 32) zu unterschiedlichen Zeitpunkten sequentiell an den Abtasttakt-Steuerungseingang der Abtast- und Halteschaltungen (16, 18, 20, 22) liefert, wobei die Abtast- und Halteschaltungen (16, 18, 20, 22) die an die analogen Signaleingänge der Abtast- und Halteschaltungen (16, 18, 20, 22) angelegten Analogspannungen der Reihe nach abtasten und halten und die Taktsteuerungseinrichtung (40) das Abtast-Endesignal (42) an den A/D-Wandler (44) liefert, nachdem die Taktgeneratoreinrichtung (24) die entsprechenden Abtasttaktsignale (26, 28, 30, 32) an alle Abtast- und Halteschaltungen (16, 18, 20, 22) geliefert hat, wobei der A/D-Wandler (44) die A/D-Wandlung erst durchführt, nachdem alle Abtast- und Halteschaltungen (16, 18, 20, 22) die an die analogen Signaleingänge der Abtast- und Halteschaltungen (16, 18, 20, 22) angelegten Analogspannungen abgetastet und gehalten haben.

## Revendications

1. Microcalculateur qui inclut une unité centrale de traitement (10) et un circuit de conversion analogique-numérique (A-N) formés sur la même puce de circuit intégré, comprenant :
une pluralité de circuits échantillonneurs et bloqueurs (16, 18, 20, 22) couplés à des moyens d'entrée (14 ; 72, 74, 76, 78) pour échantillonner et bloquer une tension analogique appliquée par l'intermédiaire des moyens d'entrée (14 ; 72, 74, 76, 78) ;
des moyens de génération de cadencement (24) couplés à la pluralité de circuits échantillonneurs et bloqueurs (16, 18, 20, 22) pour appliquer un signal de cadencement d'échantillonnage de tension analogique (26, 28, 30, 32) aux circuits échantillonneurs et bloqueurs (16, 18, 20, 22) ;
des moyens (34) couplés aux moyens de génération de cadencement (24) pour initialiser les moyens de génération de cadencement (24) ; et
des moyens (46, 48, 50, 52) couplés aux circuits échantillonneurs et bloqueurs (16, 18, 20, 22) et au circuit de conversion A-N pour sélectionner séquentiellement l'une des tensions analogiques bloquées dans les circuits échantillonneurs et bloqueurs (16, 18, 20, 22) et pour appliquer ladite tension analogique sélectionnée sur le circuit de conversion A-N de sorte que, le circuit de conversion A-N convertit séquentiellement lesdites tensions analogiques sélectionnées en données numériques une par une.

2. Microcalculateur selon la revendication 1, dans lequel les circuits échantillonneurs et bloqueurs de la pluralité de circuits échantillonneurs et bloqueurs (16, 18, 20, 22) sont couplés à une borne d'entrée analogique commune (14) et les moyens de génération de cadencement (24) génèrent un nombre correspondant de signaux de cadencement d'échantillonnage de tension analogique (26, 28, 30, 32) à différents cadencements d'intervalles constants prédéterminés et appliquent respectivement le nombre correspondant de signaux de cadencement d'échantillonnage de tension analogique (26, 28, 30, 32) sur les circuits échantillonneurs et bloqueurs (16, 18, 20, 22) de sorte que les circuits échantillonneurs et bloqueurs (16, 18, 20, 22) échantillonnent et bloquent respectivement une tension analogique sur la borne d'entrée analogique commune (14) aux cadencements différents.

3. Microcalculateur selon la revendication 2, dans lequel les moyens de génération de cadencement (24) génèrent le nombre correspondant de signaux de cadencement d'échantillonnage de tension analogique (26, 28, 30, 32) après que les moyens de génération de cadencement (24) soient initialisés par les moyens d'initialisation (34) et les moyens de génération de cadencement (24) génèrent un signal de fin d'échantillon (42) sur le circuit de conversion A-N après que les moyens de génération de cadencement (24) aient terminé la génération du nombre correspondant de signaux de cadencement d'échantillonnage de tension analogique (26, 28, 30, 32) de sorte que le convertisseur A-N démarre sa conversion A-N après que tous les circuits échantillonneurs et bloqueurs (16, 18, 20, 22) aient échantillonné et bloqué les tensions analogiques appliquées sur les entrées de signal analogique des circuits échantillonneurs et bloqueurs (16, 18, 20, 22).

4. Microcalculateur selon la revendication 1, dans lequel les circuits échantillonneurs et bloqueurs de la pluralité de circuits échantillonneurs et bloqueurs (16, 18, 20, 22) sont couplés à un nombre correspondant de bornes d'entrée analogique (72, 74, 76, 78) et les moyens de génération de cadencement (24) génèrent respectivement un signal de cadencement d'échantillonnage de tension analogique commun (80) sur les circuits échantillonneurs et bloqueurs (16, 18, 20, 22) de sorte que les circuits échantillonneurs et bloqueurs (16, 18, 20, 22) échantillonnent et bloquent respectivement des tensions analogiques sur les bornes d'entrée analogique (72, 74, 76, 78) au même cadencement.

5. Microcalculateur selon la revendication 1, dans lequel les sorties respectives des circuits échantillonneurs et bloqueurs (16, 18, 20, 22) sont couplées au circuit de conversion A-N par l'intermédiaire d'un nombre correspondant de portes de transfert (46, 48, 50, 52) qui sont commandées par le circuit de conversion A-N et qui sont ouvertes séquentiellement de sorte que des valeurs analogiques stockées dans les circuits échantillonneurs et bloqueurs (16, 18, 20, 22) sont appliquées séquentiellement une par une sur le circuit de conversion A-N.

6. Microcalculateur selon la revendication 1, dans lequel le circuit de conversion A-N inclut une pluralité de registres de conversion (62, 64, 66, 68) correspondant à la pluralité de circuits échantillonneurs et bloqueurs (16, 18, 20, 22) et fonctionne pour stocker un résultat de conversion A-N de la valeur analogique dans le registre de conversion correspondant au circuit échantillonneur et bloqueur qui a appliqué la valeur analogique sur le circuit de conversion A-N.

7. Microcalculateur selon la revendication 1, dans lequel le circuit de conversion A-N inclut :
une pluralité de circuits échantillonneurs et bloqueurs (16, 18, 20, 22) dont chacun comporte une entrée de signal analogique, une entrée de commande de cadencement d'échantillon et une sortie, chacun des circuits échantillonneurs et bloqueurs (16, 18, 20, 22) correspondant à un signal de cadencement d'échantillon (26, 28, 30, 32, 80) appliqué sur l'entrée de commande de cadencement d'échantillon en échantillonnant et en bloquant une tension analogique appliquée sur l'entrée de signal analogique et ainsi, la tension analogique bloquée dans le circuit échantillonneur et bloqueur est émise en sortie depuis la sortie du circuit échantillonneur et bloqueur ;
un convertisseur A-N (44) prévu en commun pour la pluralité de circuits échantillonneurs et bloqueurs (16, 18, 20, 22) et comportant une entrée pour recevoir séquentiellement sélectivement les sorties des circuits échantillonneurs et bloqueurs (16, 18, 20, 22) une par une et pour convertir séquentiellement la tension analogique reçue en données numériques ; et
des moyens de commande de cadencement (40) pour appliquer les signaux de cadencement d'échantillon (26, 28, 30, 32) sur l'entrée de commande de cadencement d'échantillon des circuits échantillonneurs et bloqueurs (16, 18, 20, 22) et ainsi, les circuits échantillonneurs et bloqueurs (16, 18, 20, 22) échantillonnent et bloquent les tensions analogiques appliquées sur les entrées de signal analogique des circuits échantillonneurs et bloqueurs (16, 18, 20, 22), les moyens de commande de cadencement (40) appliquant un signal de fin d'échantillon (42) sur le convertisseur A-N (44) après que tous les circuits échantillonneurs et bloqueurs (16, 18, 20, 22) aient échantillonné et bloqué les tensions analogiques appliquées sur les entrées de signal analogique des circuits échantillonneurs et bloqueurs (16, 18, 20, 22) de sorte que le convertisseur A-N (44) démarre sa conversion A-N après que tous les circuits échantillonneurs et bloqueurs (16, 18, 20, 22) aient échantillonné et bloqué les tensions analogiques appliquées sur les entrées de signal analogique des circuits échantillonneurs et bloqueurs (16, 18, 20, 22).

8. Microcalculateur selon la revendication 7, dans lequel les moyens de commande de cadencement (40) appliquent séquentiellement les signaux de cadencement d'échantillon (26, 28, 30, 32) sur l'entrée de commande de cadencement d'échantillon des circuits échantillonneurs et bloqueurs (16, 18, 20, 22) à différents cadencements et ainsi, les circuits échantillonneurs et bloqueurs (16, 18, 20, 22) échantillonnent et bloquent séquentiellement les tensions analogiques appliquées sur les entrées de signal analogique des circuits échantillonneurs et bloqueurs (16, 18, 20, 22) et les moyens de commande de cadencement (40) appliquent le signal de fin d'échantillon (42) sur le convertisseur A-N (44) après que les moyens de génération de cadencement (24) aient appliqué les signaux de cadencement d'échantillonnage correspondants (26, 28, 30, 32) sur tous les circuits échantillonneurs et bloqueurs (16, 18, 20, 22) de sorte que le convertisseur A-N (44) exécute sa conversion A-N après que tous les circuits échantillonneurs et bloqueurs (16, 18, 20, 22) aient échantillonné et bloqué les tensions analogiques appliquées sur les entrées de signal analogique des circuits échantillonneurs et bloqueurs (16, 18, 20, 22).
